# EUROPEAN PATENT SPECIFICATION

(11) **EP 3 879 382 B1**
(45) Date of publication and mention of the grant of the patent: **16.11.2022**
(21) Application number: 20162914.4
(22) Date of filing: 13.03.2020
(51) Int. Cl.: G06F 1/20, H01L 23/473

(54) **COOLING DEVICE FOR A COMPUTER MODULE**
KÜHLVORRICHTUNG FÜR EIN COMPUTERMODUL
DISPOSITIF DE REFROIDISSEMENT POUR UN MODULE D'ORDINATEUR

(43) Date of publication of application: 15.09.2021
(73) Proprietor: EKWB d.o.o., 1218 Komenda (SI)
(72) Inventor: SIKOVEC, Simon, 1410 Zagorje ob Savi (SI)
(74) Representative: Schaumburg und Partner Patentanwälte mbB

(56) References cited:
- WO-A1-2007/048686
- DE-U1-202013 011 767
- US-A1- 2013 255 917
- US-A1- 2019 387 609
- US-B1- 10 431 524

## Description

### Technical field

The present invention relates to a cooling device for a computer module. Further, the present invention relates to a computer module comprising a cooling device, and a method for installing a cooling device in a computer module.

### Background

Waste heat produced by a computer component is required to be removed by a suitable computer cooling system in order to keep the computer component within permissible operating temperature limits. Whereas computer operating systems may be designed to reduce power consumption and consequent heating according to workload, high-performance computer components including integrated circuits such as central processing units (CPUs), graphics processing units (GPUs), etc. require efficient cooling to prevent overheating. For this, a cooling system may be designed to reduce the ambient temperature within the case of a computer, such as by exhausting hot air by means of computer fans. Further, a more sophisticated approach is liquid cooling which may be individually applied to powerful computer components as CPUs or GPUs.

When applying liquid cooling, a liquid coolant, e.g. water, may be circulated in a closed loop through a plurality of interconnected coolant blocks, each of which being mounted on an individual computer component. Each individual coolant block comprises an inlet port, which allows the coolant to flow into the coolant block, and an outlet port, which allows the coolant to flow out of the coolant block. For interconnecting the coolant blocks in pairs, a plurality of hard plastic or soft rubber tubes are provided, each tube coupling an outlet port of one coolant block with an inlet port of another coolant block. Connecting multiple coolant blocks by means of a plurality of tubes is a time-consuming process as the pairs of coolant blocks must sequentially be connected with a large number of tubes. Further, such a large number of tubes results in a space-filling, untidy configuration including a plurality of tube loops affecting consumer acceptance. The following documents relate to a cooling device for a computer: US 2013/255917 A1, WO 2007/048686 A1, US 2019/387609 A1, US 10431524 B1, DE 202013011767 U1.

### Summary

It is an object of the present invention to provide a cooling device for a computer module which allows to interconnect a plurality of coolant blocks by means of a compact design. Further, it is an object of the invention to provide a method for installing a cooling device in a computer module which facilitates an interconnection of a plurality of coolant blocks of the cooling device.

The afore-mentioned objects are achieved by the subject-matter of the independent claims. Advantageous embodiments are defined in the dependent claims and the following description.

A cooling device for a computer module comprises a first coolant block configured to be mounted on a first computer component and at least a second coolant block configured to be mounted on a second computer component, wherein each of the first and second coolant blocks comprises an inlet port configured to allow a coolant to flow into the coolant block and an outlet port configured to allow the coolant to flow out of the coolant block. The cooling device further comprises a connecting structure configured to connect the outlet port of the first coolant block with the inlet port of the second coolant block. The connecting structure comprises a distribution plate configured to be mounted onto the first and second coolant blocks, wherein the distribution plate includes a block interconnecting channel configured to connect the outlet port of the first coolant block with the inlet port of the second coolant block for allowing the coolant to flow from said outlet port to the said inlet port.

Using a distribution plate including a block interconnecting channel rather than connecting tubes enables the coolant blocks to be interconnected by means of a compact and easily mountable design. Thus, the distribution plate can be installed as a single unit onto the whole of the coolant blocks so that the overall height of the connecting structure is uniformly limited to the thickness of the distribution plate. As a result, a compact design of the cooling device is achieved.

In a preferred embodiment, the distribution plate further includes an inlet opening configured to be connected with an inlet tube for introducing the coolant into the cooling device, wherein the inlet opening of the distribution plate is configured to communicate with the inlet port of the first coolant block.

Advantageously, the afore-mentioned inlet opening is formed by one single opening so that only one single inlet tube is required to introduce the liquid coolant into the cooling device. The inlet tube may be formed from a hard plastic or soft rubber material.

Preferably, the distribution plate further includes a coolant output channel configured to connect the outlet port of the second coolant block with an outlet opening of the distribution plate, wherein the outlet opening of the distribution plate is configured to be connected with an outlet tube for outputting the coolant from the cooling device. Like the inlet opening, also the outlet opening is preferably formed by one single opening. Accordingly, only one single outlet tube is required to output the coolant from the cooling device.

As the preferred embodiment of the cooling device includes only one single inlet opening and one single outlet opening formed on the distribution plate, only a number of two tubes are required to implement the coolant circuit irrespective of the number of coolant blocks through which the coolant flows from the inlet opening to the outlet opening. In other words, in contrast to conventional cooling systems known in the art, the number of hard plastic or soft rubber tubes do not increase depending on the number of coolant blocks which have to be implemented in the coolant circuit. In this respect, it is to be noted that the inlet opening and the outlet opening of the distribution plate may be coupled to a coolant reservoir and a radiator, respectively, without being limited thereto.

The distribution plate may be attached directly or indirectly to the first and second coolant blocks. In case of an indirect attachment, the cooling device may comprise a fixation plate which is configured to be mounted onto the first and second coolant blocks, wherein the distribution plate is configured to be mounted onto the fixation plate.

Preferably, each of the inlet and outlet ports of the first and second coolant blocks is provided with a fitting which is configured to be connected with the distribution plate. The fixation plate may comprise a plurality of through holes, each of which being assigned to one of the fittings, and each fitting may be configured to pass through the corresponding through hole of the fixation plate for connecting the fitting with the distribution plate. In this embodiment, each of the inlet and outlet ports of the coolant blocks may be provided with a female thread into which a male thread formed on the corresponding fitting may be screwed in order to attach the fitting on the coolant block.

According to a specific embodiment, the fitting provided to the inlet port of the first coolant block may be configured to be connected with the inlet opening of the distribution plate. The fitting provided to the outlet port of the first coolant block may be configured to be connected with an inlet end of the block interconnecting channel of the distribution plate. The fitting provided to the inlet port of the second coolant block may be configured to be connected with an outlet end of the block interconnecting channel of the distribution plate. The fitting provided to the outlet port of the second coolant block may be configured to be connected with an inlet end of the coolant output channel of the distribution plate.

The fixation plate interposed between the distribution plate and the coolant blocks may serve to facilitate the assembly process by which the distribution plate is mounted onto the coolant blocks. For instance, the fixation plate may be movable from an unlocked position, in which each fitting is unlocked within the corresponding through hole of the fixation plate, into a locked position, in which each fitting is locked within the corresponding through hole of the fixation plate. Thus, in a first step, the fixation plate may be put onto the fittings so that each fitting is freely movable within the corresponding through hole of the fixation plate in a vertical direction in which the fixation plate is put on from above. In a second step, the fixation plate may be moved perpendicular to the vertical direction in order to lock each fitting within the corresponding through hole of the fixation plate. Further, when the fixation plate has been locked as described above, the distribution plate may be put onto the fixation plate and fixed thereto e.g. by means of a screwed connection. For this purpose, the distribution plate may have a plurality of through holes through which screws are inserted in order to be engaged with a plurality of corresponding threads which are formed on the fixation plate.

In a preferred embodiment, each fitting comprises a shaft and a circumferential flange radially protruding therefrom. Each through hole comprises an insertion hole portion and a locking hole portion, said insertion hole portion having a cross section being larger than a cross section of the flange and said locking hole portion having a cross section being smaller than the cross section of the flange. The flange is positioned in an unlocked manner within the insertion hole portion when the fixation plate is in the unlocked position. In contrast, the flange is positioned in a locked manner within the locking hole portion when the fixation plate is in the locked position.

Preferably, the distribution plate is formed by two plates which are attached to each other, for instance by screws or glue. Each of the block interconnecting channel and the coolant output channel may be defined by a groove, said groove being formed in one of the plates and being covered by the other plate. Thus, assuming a vertically stacked configuration comprising a top plate and a bottom plate, the channels may be formed in the bottom plate and be covered by the top plate or vice versa. Alternatively, one portion of the respective channel may be formed in the bottom plate and the other portion be formed in the top plate so that these channel portions are combined to the respective channel when attaching the plates together. Needless to say that this embodiment is to be understood merely as an example. For instance, only one of the block interconnecting channel and the coolant output channel may be formed as described above, whereas the other channel may be formed in a different manner, for instance by embedding the channel as a whole in one of the plates.

According to another aspect, a computer module is provided, comprising a first computer component, at least a second computer component and a cooling device for cooling the first and second computer components as described above. The computer components to be cooled are not restricted to specific integrated circuits. Just as an example, powerful components as a CPU or a GPU may be included in the computer module.

The first and second coolant blocks may be mounted on a circuit board which carries the afore-mentioned computer components. In particular, the circuit board may be a motherboard carrying powerful integrated circuits as CPUs and GPUs.

According to another aspect, a method is provided for installing a cooling device in a computer module including a first computer component and at least a second computer component, wherein the cooling device comprises a first coolant block and at least a second coolant block, each of the first and second coolant blocks comprising an inlet port configured to allow a coolant to flow into the coolant block and an outlet port configured to allow the coolant to flow out of the coolant block. The method comprises the following steps: mounting the first coolant block onto the first computer component; mounting the second coolant block onto the second computer component; and connecting the outlet port of the first coolant block with the inlet port of the second coolant block by means of a connecting structure. The connecting structure comprises a distribution plate including a block interconnecting channel, wherein the distribution plate is mounted onto the first and second coolant blocks thereby connecting the outlet port of the first coolant block with the inlet port of the second coolant block by means of the interconnecting channel for allowing the coolant to flow from said outlet port to said inlet port.

Preferably, the outlet port of the second coolant block is connected with the outlet opening of the distribution plate by means of the coolant output channel of the distribution plate by mounting the distribution plate onto the first and second coolant blocks.

Further, according to a preferred embodiment, the inlet opening of the distribution plate is connected with an inlet tube for introducing the coolant into the cooling device and the outlet opening of the distribution plate is connected with an outlet tube for outputting the coolant from the cooling device.

### Short description of the Figures

Hereinafter, a specific embodiment is described referring to the drawings, wherein:
- Figure 1: is a perspective view showing a cooling device according to an embodiment in a completely assembled state,
- Figure 2: is a side view of the cooling device,
- Figure 3: is a plan view of the cooling device,
- Figure 4: is a perspective exploded view of the cooling device,
- Figure 5: is a perspective view of the cooling device specifically illustrating a distribution plate including a block interconnecting channel and a coolant output channel,
- Figure 6: is a perspective exploded view of the cooling device specifically illustrating the distribution plate including the block interconnecting channel and the coolant output channel,
- Figure 7: is a sectional side view of the cooling device,
- Figure 8: is a plan view of the cooling device specifically illustrating the block interconnecting channel and the coolant output channel of the distribution plate,
- Figure 9: is a perspective view illustrating the beginning of a process for installing the cooling device on a circuit board,
- Figure 10: is a perspective view illustrating a next step of the installation process in which a coolant block is mounted onto a CPU,
- Figure 11: is a perspective view illustrating a next step of the installation process in which fittings are mounted onto the coolant blocks,
- Figure 12: is a perspective view illustrating a next step of the installation process in which a fixation plate is put onto the coolant blocks and locked thereon,
- Figure 13: is a perspective view illustrating a next step of the installation process in which the distribution plate is put onto the fixation plate,
- Figure 14: is a perspective view illustrating a next step of the installation process in which the distribution plate is fixed onto the fixation plate by means of fixation screws,
- Figure 15: is a perspective view illustrating a next step of the installation process in which tube fittings are mounted onto the distribution plate,
- Figure 16: is a perspective view illustrating a next step of the installation process in which inlet and outlet tubes are connected to the tube fittings,
- Figure 17: is a plan view further illustrating the step for mounting the fixation plate onto the coolant blocks, wherein the fixation plate is moved towards the fittings,
- Figure 18: is a sectional side view further illustrating the step shown in Figure 17,
- Figure 19: is a plan view illustrating the step for mounting the fixation plate onto the coolant blocks, wherein the fixation plate is located in an unlocked position,
- Figure 20: is a sectional side view further illustrating the step of Figure 19,
- Figure 21: is a plan view illustrating the step for mounting the fixation plate onto the coolant blocks, wherein the fixation plate is located in a locked position,
- Figure 22: is a sectional view further illustrating the step shown in Figure 21,
- Figure 23: is an enlarged sectional view illustrating a mechanism for locking the fixation plate onto the fittings in more detail,
- Figure 24: is a perspective view showing a cooling device including soft rubber tubes for implementing the coolant circuit as a comparative example, and
- Figure 25: is a perspective view showing a cooling device including hard plastic tubes for implementing the coolant circuit as another comparative example.

### Detailed description

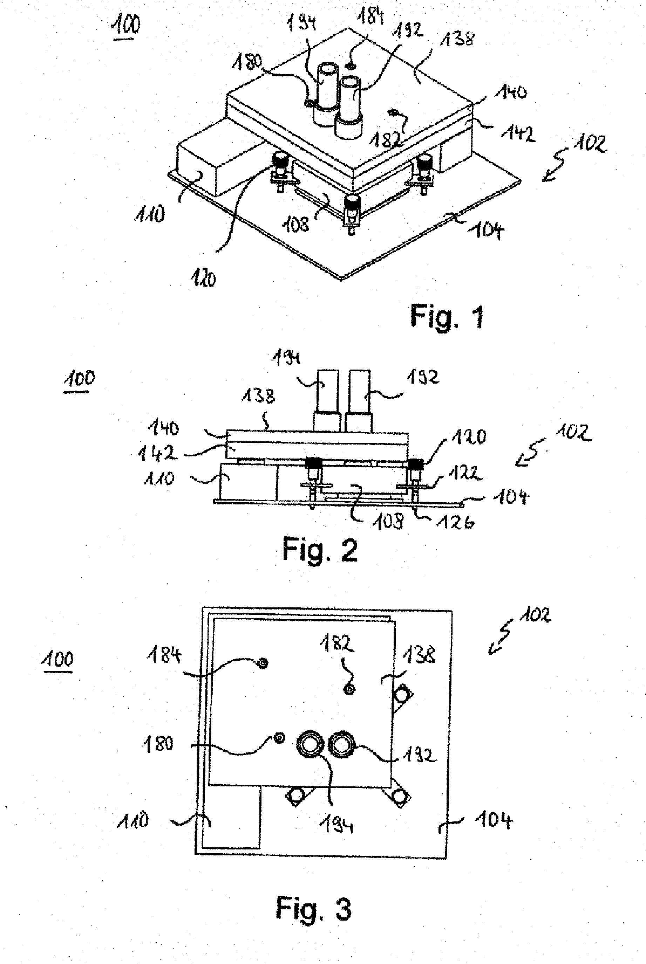

Figures 1 to 4 show a cooling device 100 according to an embodiment of the present invention in a perspective view, a side view, a plan view, and an exploded view, respectively. According to the embodiment shown in Figures 1 to 4, it is assumed that the cooling device 100 is configured to provide liquid cooling to a computer module 102 which comprises a circuit board 104 on which two computer components are mounted. One of these computer components may be a CPU 106, and the other computer component (not shown in the Figures) may be a GPU. Needless to say that such a configuration is to be understood merely as an example, and any other configuration including a different number of computer components and/or computer components of different types are conceivable.

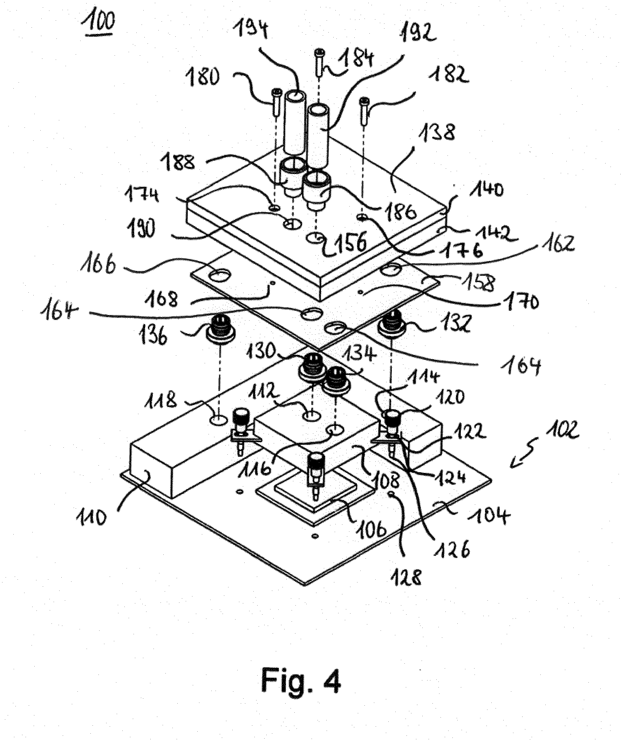

As can be seen in the exploded view of Figure 4, the cooling device 100 comprises a first coolant block 108 which is to be mounted onto the CPU 106 in order to transfer heat from the CPU 106 into the liquid coolant that flows through the coolant block 108. The liquid coolant may be water or any other liquid substance which is suitable to achieve the intended heat transfer from the CPU 106 to the coolant block 108. The coolant block 108 may comprise a plurality of micro fins (not shown in the Figures) that increase a cooling surface of the coolant block 108.

The cooling device 100 further comprises a second coolant block 110 which may have an L-shape according to the specific embodiment shown in Figures 1 to 4. As in the case of the first coolant block 108, also the second coolant block 110 is mounted onto a computer component (not shown in Figures 1 to 4) for transferring heat from the computer component into the liquid coolant flowing through the second coolant block 110. Apart from the specific shape, the second coolant block 110 may be essentially identical to the first coolant block 108.

In particular, each of the first and second coolant blocks 108, 110 comprises an inlet port 112 and 114, respectively, and each of the first and second coolant blocks 108, 110 comprises an outlet port 116 and 118, respectively. The inlet port 112 of the first coolant block 108 allows the coolant to flow into the first coolant block 108, whereas the outlet port 116 of the first coolant block 108 allows the coolant to flow out of the first coolant block 108. Likewise, the inlet port 114 of the second coolant block 110 allows the coolant to flow into the second coolant block 110, whereas the outlet port 118 of the second coolant block 110 allows the coolant to flow out of the second coolant block 110.

In order to attach the first coolant block 108 on the circuit board 104 such that a lower surface of the first coolant block 108 comes into thermal contact with the CPU 106 to be cooled, a plurality of fasteners 120 may be provided on corner portions of the rectangular shaped first coolant block 108. Each fastener may comprise a bracket 122 with a through hole 124, said bracket 122 being attached to the respective corner portion of the first coolant block 108. The respective fastener 122 may further comprise a threaded bolt 126 passing through the through hole 124 of the bracket 122 and engaging with a corresponding thread 128 formed in the circuit board 104. The structure of the fasteners 120 as explained above is to be understood only as an example. For instance, rather than the thread 128, a through hole may be provided in the circuit board 104, and the threaded bolt 126 may be engaged with a back plate attached to a lower surface of the circuit board 104, said back plate having a corresponding thread.

Further, any other fixation means may be provided to attach the first coolant block 108 onto the circuit board 104. The same applies for the second coolant block 110, a fixation means for mounting the second coolant block 110 onto the circuit board not being shown in the Figures.

As can be seen in the exploded view of Figure 4, a plurality of fittings 130, 132, 134 and 136 are provided, each of these fittings being configured to be mounted into one of the inlet and outlet ports 112 to 118 of the first and second coolant blocks 108 and 110, respectively. Specifically, the fitting 130 is inserted into the inlet port 112 of the first coolant block 108 and secured therein. Likewise, the fitting 132 is secured in the inlet port 114 of the second coolant block 110, the fitting 134 is secured in the outlet port 116 of the first coolant block 108, and the fitting 136 is secured in the outlet port 118 of the second coolant block 110.

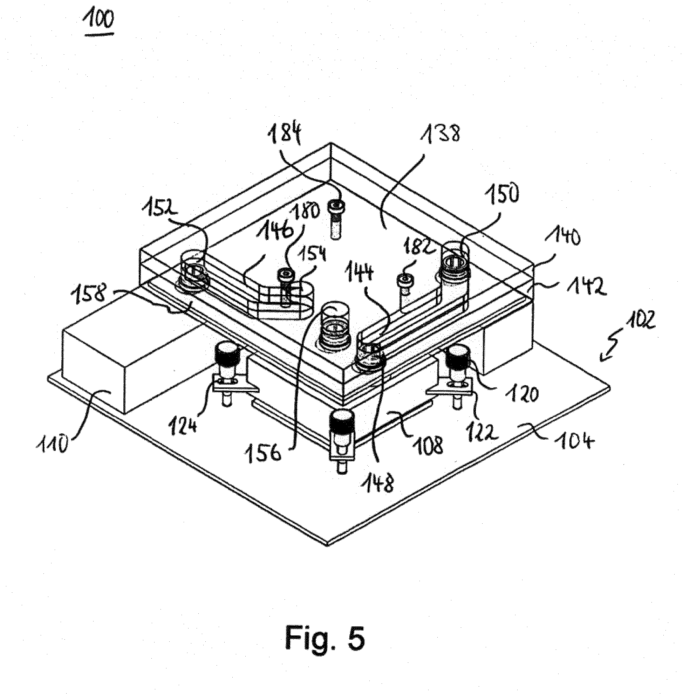

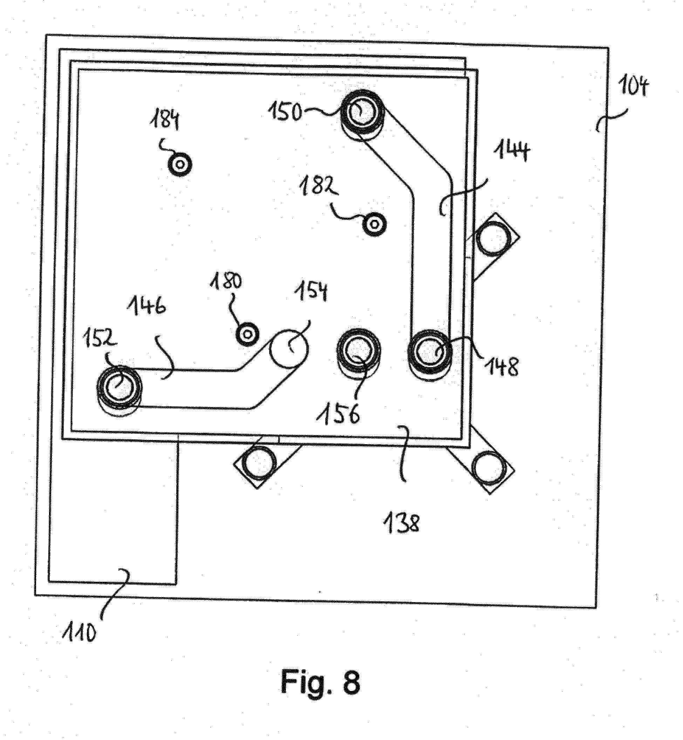

The cooling device 100 further comprises a distribution plate 138 which forms a connecting structure being configured to interconnect the first and second coolant blocks 108, 110 for implementing a coolant circuit as explained hereinafter with further reference to Figures 5 to 8. Specifically, the diagrams of Figures 5 to 8 showing the distribution plate 138 in perspective view, exploded view, plan view, and sectional view, respectively, serve to illustrate an internal structure of the distribution plate 138 which is adapted to implement the coolant circuit.

The distribution plate 138 may be formed by a top plate 140 and a bottom plate 142 which are attached to each other by suitable means as screws (not shown in the Figures) or glue. As illustrated in Figures 5 to 7, the distribution plate 138 includes a block interconnecting channel 144 and a coolant output channel 146. Each of the block interconnecting channel 144 and the coolant output channel 146 may be defined by a groove which is formed in the bottom plate 142 and covered by a lower surface of the top plate 140 which is affixed to the bottom plate 142. Alternatively, the groove may be formed in the top plate 140 and covered by an upper surface of the bottom plate 142. Further, it is also possible that both plates 140, 142 comprise groove portions on their lower and upper surfaces, respectively, these groove portions facing each other so that the respective channel 144, 146 is formed by the combination of the groove portions. As explained below in more detail, the block interconnecting channel 144 forms a part of the coolant circuit. Specifically, the coolant enters the block interconnecting channel 144 through an inlet end 148 thereof and flows out of the block interconnecting channel 144 from an outlet end 150 thereof. Likewise, the coolant output channel 146 forms a part of the cooling circuit, wherein the coolant enters the coolant output channel 146 via an inlet end 152 thereof and leaves the coolant output channel 146 via an outlet end 154 thereof. Further, the distribution plate 138 comprises an inlet opening 156 which serves to introduce the coolant into the cooling device 100.

The cooling device 100 further comprises a fixation plate 158 which is interposed between the distribution plate 138 and the coolant blocks 108, 110 as shown in Figures 4 to 7. The fixation plate 158 is used to mount the distribution plate 138 onto the coolant blocks 108,110. For this, the fixation plate 158 comprises a plurality of through holes 160, 162, 164, and 166, each of which being assigned to one of the fittings 130, 132, 134, and 136, respectively, as shown in Figure 4. Further, the fixation plate 158 comprises a plurality of fixation threads 168, 170, 172, each of which being assigned to one of a plurality of through holes 174, 176, and 178, respectively, which are formed on the distribution plate 138. As can be seen in Figure 4, a plurality of fixation screws 180, 182, and 184 can be inserted into the through holes 174, 176, and 178, respectively, in order to be engaged with the fixation threads 168, 170, and 172 for attaching the distribution plate 138 onto the fixation plate 158.

The cooling device 100 further comprises an inlet tube fitting 186 and an outlet tube fitting 188. The inlet tube fitting 186 is configured to be inserted into the inlet opening 156 of the distribution plate 138. Likewise, the outlet tube fitting 188 is configured to be inserted into an outlet opening 190 formed by the outlet end 154 of the coolant output channel 146. The inlet tube fitting 186 can be connected with an inlet tube 192 which serves to introduce the coolant into the cooling device 100. Likewise, the outlet tube fitting 188 can be connected with an outlet tube 194 which serves to output the coolant from the cooling device 100.

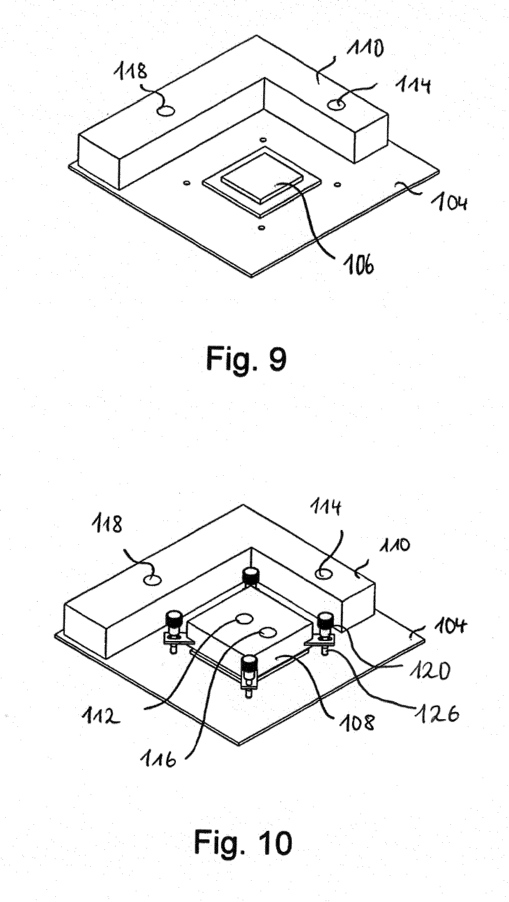

In the following, a process for installing the cooling device 100 onto the computer module 102 is described with reference to Figures 9 to 16.

Figure 9 shows a state in which only the L-shaped coolant block 110 is mounted onto the computer component assigned thereto (not shown in Figure 9). In particular, the coolant block 108 is not yet mounted onto the CPU 106 in the assembly state shown in Figure 9.

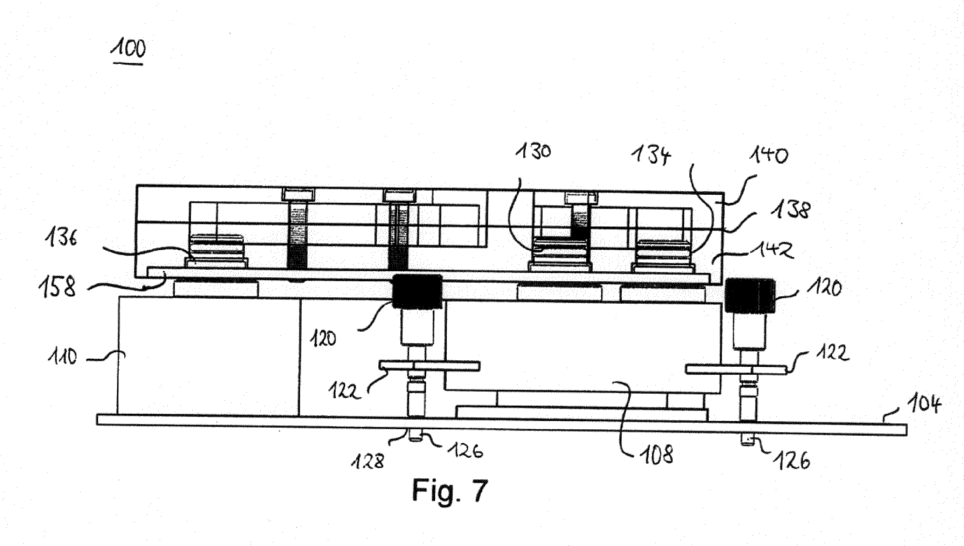

Starting from the state shown in Figure 9, the coolant block 110 is put onto the CPU 106 and fixed by means of the fasteners 120 onto the circuit board 104 in order to establish thermal contact between the lower surface of the coolant block 108 and the upper surface of the CPU 106. Specifically, the threaded bolts 126 are screwed into the corresponding threads 128 which are formed in the circuit board 104 for creating contact between the coolant block 108 and the CPU 106 (see Figure 7).

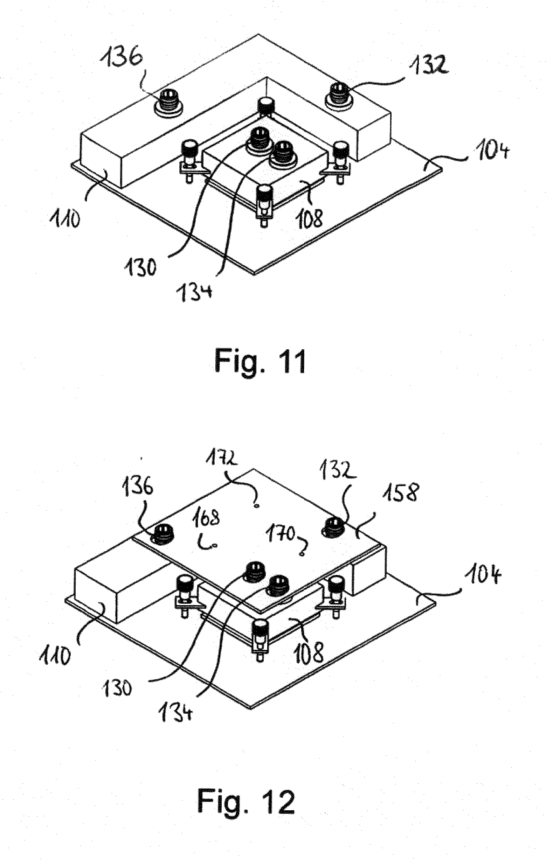

Subsequently, as shown in Figure 11, the fittings 130, 132, 134, 136 are mounted into the inlet and outlet ports 112, 114, 116, 118 of the first and second coolant blocks 108, and 110, respectively. Each of the inlet and outlet ports 112, 114, 116, 118 may comprise a female thread to be engaged with a male thread which is formed on the corresponding fitting 130, 132, 134, 136.

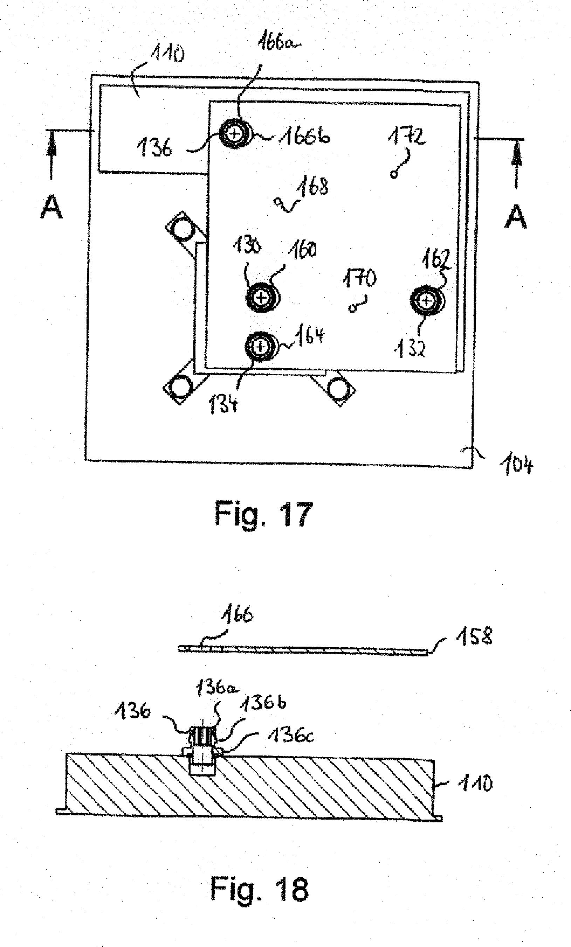

Then, as shown in Figure 12, the fixation plate 158 is mounted onto the first and second coolant blocks 108, 110 and locked thereon. Specifically, the fixation plate 158 is moved from above towards the coolant blocks 108, 110 so that the fittings 130, 132, 134, 136 penetrate the corresponding through holes 160, 162, 164, 166 formed in the fixation plate 158. In a state in which the fittings 130 to 136 are inserted into the corresponding through holes 160 to 166, the fixation plate 158 is shifted in a horizontal direction from an unlocked position into a locked position in which each fitting 130 to 136 is locked within the corresponding through hole 160 to 166. Both the fittings 130 to 136 and the through holes 160 to 166 formed in the fixation plate 158 are configured to form a lock mechanism which is described below in more detail with reference to Figure 17 to 23.

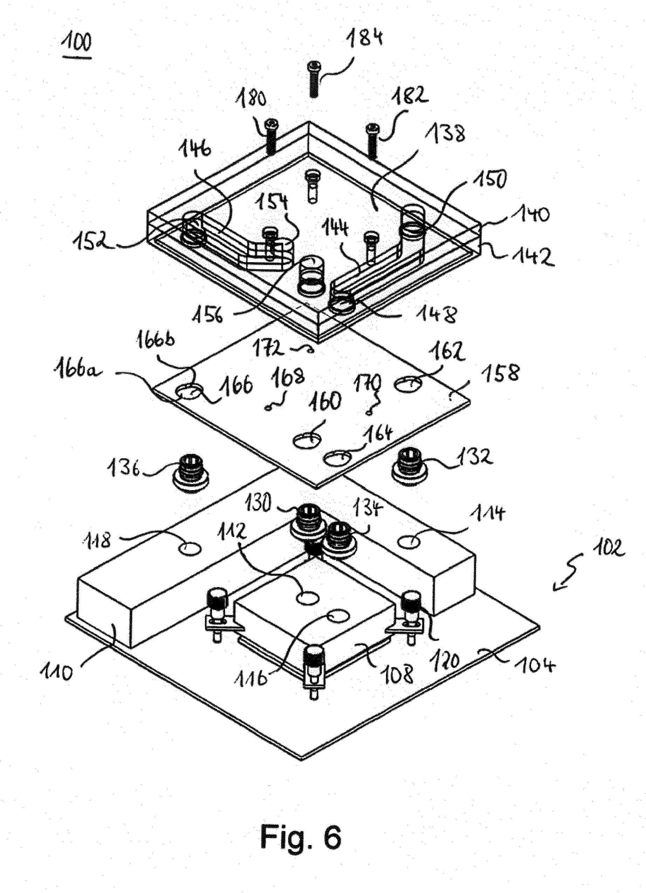

With the fixation plate 158 being locked onto the first and second coolant blocks 108, 110, the distribution plate 138 is put onto the fixation plate 158 thereby connecting the inlet and outlet ports 112 to 118 of the first and second coolant blocks 108, 110 via the fittings 130 to 136 with the distribution plate 138. More specifically, the fitting 130 inserted in the inlet port 112 of the first coolant block 108 is connected with the inlet opening 156 of the distribution plate 138, as shown in Figure 6. Likewise, the fitting 134 inserted in the outlet port 116 of the first coolant block 108 is connected with the inlet end 148 of the block interconnecting channel 144 formed in the distribution plate 138. The fitting 132 inserted in the inlet port 114 of the second coolant block 110 is connected with the outlet end 150 of the block interconnecting channel 144 formed in the distribution plate 138. The fitting 136 inserted in the outlet port 118 of the second coolant block 110 is connected with the inlet end 152 of the coolant output channel 146 formed in the distribution plate 138.

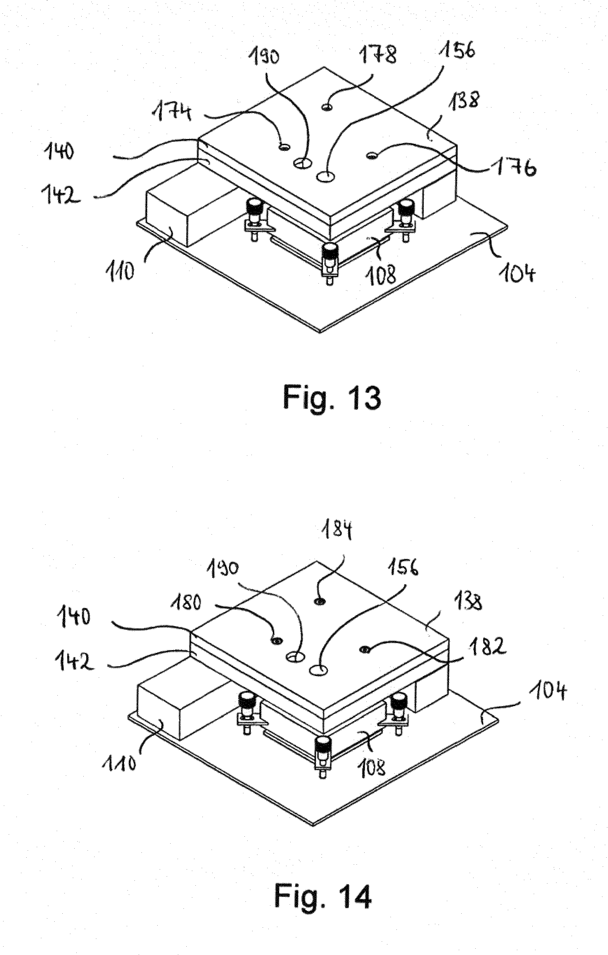

Subsequently, as shown in Figure 14, the distribution plate 138 is firmly attached on the fixation plate 158 by engaging the fixation screws 180, 182, 184 with the fixation threads 168, 170, 172 formed in the fixation plate 158.

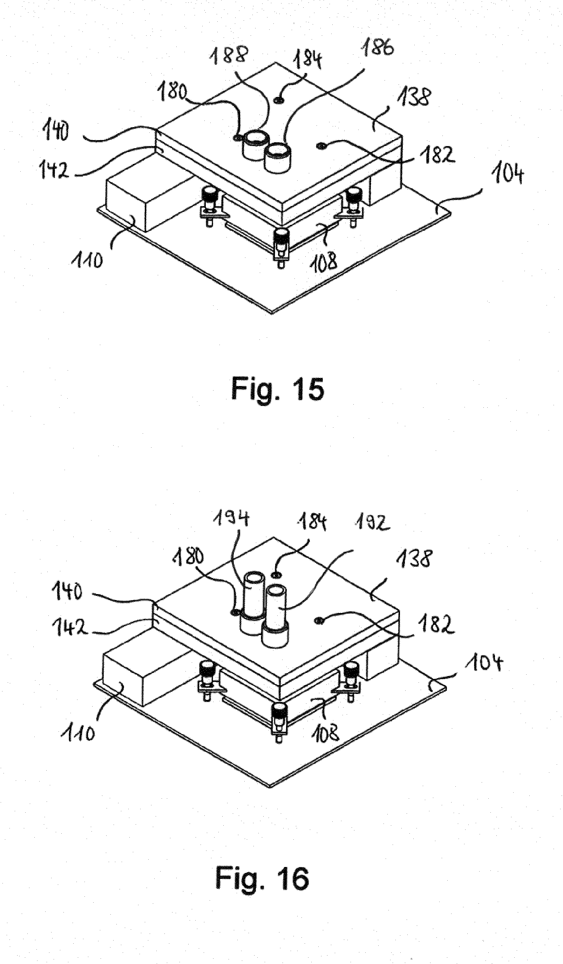

In a next step shown in Figure 15, the inlet tube fitting 186 is inserted into the inlet opening 156 formed in the distribution plate 138. Likewise, the outlet tube fitting 188 is inserted into the outlet opening 190 formed in the distribution plate 138.

Finally, as shown in Figure 16, the inlet tube 192 is connected with the inlet tube fitting 186, and the outlet tube 194 is connected with the outlet tube fitting 188.

As a result of the assembly process described above, the cooling device 100 is installed in a computer module 102 so that a coolant circuit is implemented, an input of the coolant circuit being formed by the inlet tube 192 and an output of the coolant circuit being formed by the outlet tube 194. Thus, the coolant introduced into the inlet tube 192 flows into the first coolant block 108 through the inlet port 112 and flows out of the first coolant block 108 through the outlet port 116. Then, the coolant flows into the block interconnecting channel 144 through the inlet end 148 thereof and flows out of the block interconnecting channel 144 through the outlet end 150 thereof. Subsequently, the coolant flows into the second coolant block 110 through the inlet port 114 and flows out of the second coolant block 110 through the outlet port 118. The coolant then flows into the coolant output channel 146 through the inlet end 152 thereof. Finally, the coolant flows out of the outlet end 154 of the coolant output channel 146 to be output by the outlet tube 154.

Hereinafter, a mechanism for locking the fixation plate 158 onto the fittings 130 to 136 is explained in more detail.

As shown in Figure 6, each of the through holes 160 to 166 comprises an insertion hole portion with a larger cross section and a locking hole portion with a smaller cross section. Regarding e.g. the through hole 166, the insertion hole portion is designated by 166a and the locking hole portion by 166b. Further, each of the fittings 130 to 136 is configured to be positioned in an unlocked manner within the corresponding insertion hole portion, when the fixation plate 158 is in the unlocked position, and each of the fittings 130 to 136 is configured to be positioned in a locked manner within the corresponding locking hole portion when the fixation plate 158 is in the locked position.

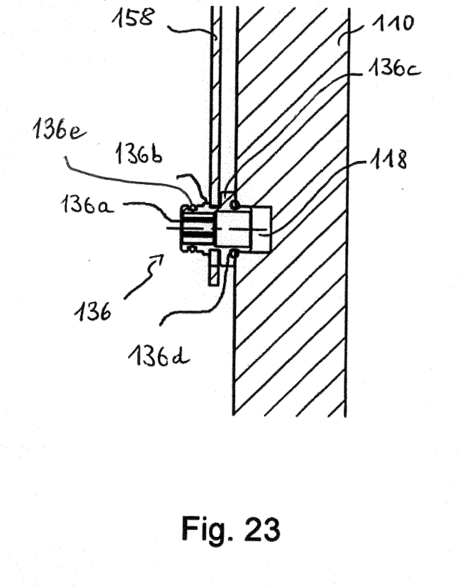

Figure 23 illustrates an appropriate configuration using the fitting 136 as an example. Thus, the fitting 136 comprises a shaft 136a and a circumferential flange 136b which radially protrudes from the shaft 136a. The fitting 136 is mounted in the outlet port 118 by means of a first O-ring 136d, which is pressed onto a surface of the coolant block 110 by means of a flange-like base portion 136c of the fitting 136. Further, the fitting 136 comprises a second O-ring 136e which serves to mount the fitting 136 to the distribution plate 138. Needless to say that an identical structure is provided for the other fittings 130 to 134.

The through holes 160 to 166 on the one hand and the fittings 130 to 136 on the other hand are adapted to each other in terms of shape and dimensions such that the intended locking effect is achieved. In this respect, further reference is made to Figures 17 to 22 which illustrate the assembly step of locking the fixation plate 158 onto the fittings 130 to 136. Figure 17, 19, and 21 are plan views, and Figures 18, 20, and 22 are sectional views in a direction A-A shown in Figures 17, 19, and 21.

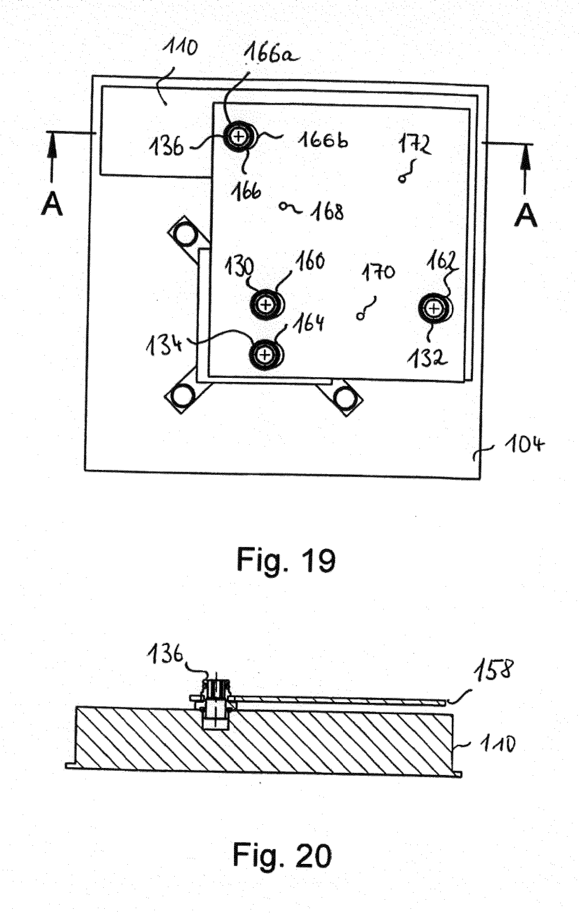

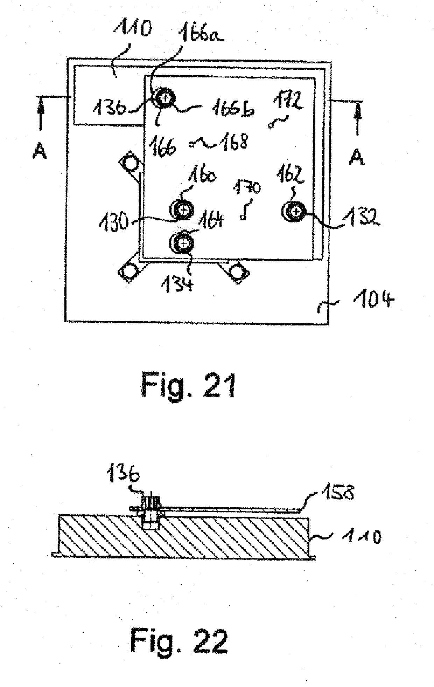

Figure 17 and 18 illustrate a state in which the fixation plate 158 is moved from above towards the fittings 130 to 136. Figures 19 and 20 illustrate a state, in which the fixation plate 158 is put onto the fittings 130 to 136 but not yet locked thereon. In this state, the respective fitting (as for instance the fitting 136) is located in the insertion hole portion 166a of the corresponding through hole 166 formed in the fixation plate 158. Finally, Figures 21 and 22 illustrate a state, in which the fixation plate 158 is locked onto the fittings 130 to 136. In this state, the fitting 136 is located in the locking hole portion 166b of the through hole 166. Thus, the state illustrated in Figures 21 and 22 correspond to the situation shown in Figure 23 in which the fixation plate 158 is locked between the flange 136b and the base portion 136c of the fitting 136.

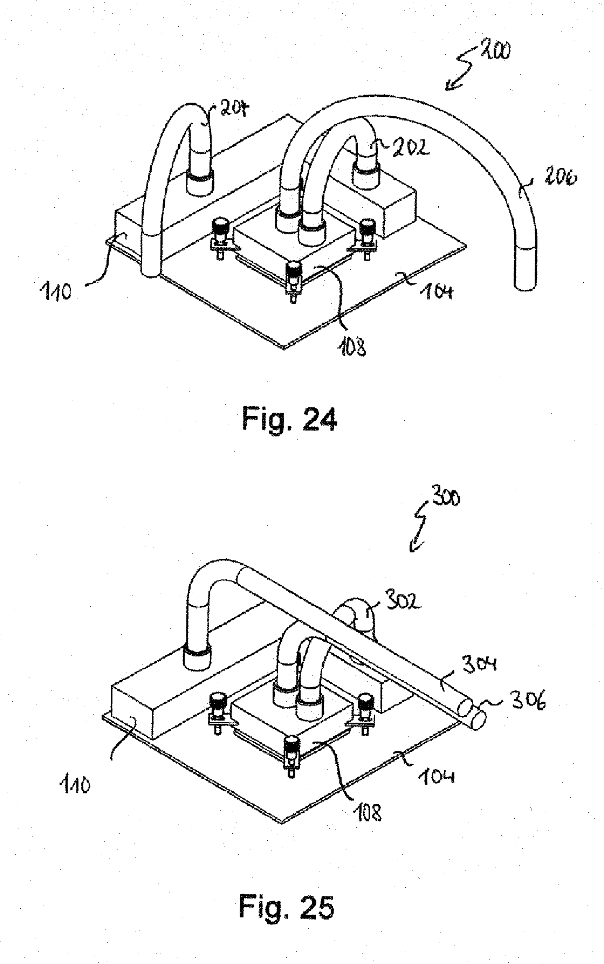

As can be understood from the embodiment described above, the present invention allows to interconnect the coolant blocks 108, 110 by means of the distribution plate 138 which can be formed in a compact design. In particular, a large number of hard plastic or soft rubber tubes for interconnecting the coolant blocks can be avoided. For illustrating this advantageous technical effect, reference is made to Figures 24 and 25 showing comparative examples which do not use a distribution plate according to the present invention. Components of these comparative examples which correspond to the components of the embodiment in terms of structure and/or function are designated with reference signs already used in the preceding Figures.

Figure 24 shows a cooling device 200 as a comparative example including a plurality of soft rubber tubes 202, 204, and 206, these tubes being used for interconnecting the coolant blocks 108, 110 as well as for introducing the coolant into the cooling device 200 and for outputting the coolant out of the cooling device 200. As can be seen in Figure 24, the number of tubes 202, 204, 206 results in a space-filling, untidy configuration including a plurality of tube loops. Further, it is evident that the cooling device 200 of Figure 24 requires a time-consuming process for installing the coolant circuit, in particular with an increasing number of coolant blocks.

A cooling device 300 as another comparative example is shown in Figure 25, this example using hard plastic tubes 302, 304, and 306 instead of soft rubber tubes. Although the configuration of Figure 25 is somewhat improved in terms of space required by the tubes and tidiness of the configuration compared to Figure 24, the example of Figure 25 does not achieve the advantageous effect of the present embodiment using the distribution plate 138 either. In particular, also the cooling device 300 requires a time-consuming process for installing the coolant circuit.

### List of reference signs

- 100: cooling device
- 102: computer module
- 104: circuit board
- 106: CPU
- 108: first coolant block
- 110: second coolant block
- 112: inlet port
- 114: inlet port
- 116: outlet port
- 118: outlet port
- 120: fastener
- 122: bracket
- 124: through hole
- 126: threaded bolt
- 128: thread or through hole
- 130: fitting
- 132: fitting
- 134: fitting
- 136: fitting
- 136a: shaft
- 136b: flange
- 136c: base portion
- 136d: O-ring
- 136e: O-ring
- 138: distribution plate
- 140: top plate
- 142: bottom plate
- 144: block interconnecting channel
- 146: coolant output channel
- 148: inlet end
- 150: outlet end
- 152: inlet end
- 154: outlet end
- 156: inlet opening
- 158: fixation plate
- 160: through hole
- 162: through hole
- 164: through hole
- 166: through hole
- 166a: insertion hole portion
- 166b: locking hole portion
- 168: fixation thread
- 170: fixation thread
- 172: fixation thread
- 174: through hole
- 176: through hole
- 178: through hole
- 180: fixation screw
- 182: fixation screw
- 184: fixation screw
- 186: inlet tube fitting
- 188: outlet tube fitting
- 190: outlet opening
- 192: inlet tube
- 194: outlet tube
- 200: cooling device
- 202: tube
- 204: tube
- 206: tube
- 300: cooling device
- 302: tube
- 304: tube
- 306: tube

## Claims

1. A cooling device (100) for a computer module (102), comprising:
a first coolant block (108) configured to be mounted on a first computer component (106) and at least a second coolant block (110) configured to be mounted on a second computer component, wherein each of the first and second coolant blocks (108, 110) comprises an inlet port (112, 114) configured to allow a coolant to flow into the coolant block (108, 110) and an outlet port (116, 118) configured to allow the coolant to flow out of the coolant block (108, 110), and
a connecting structure configured to connect the outlet port (116) of the first coolant block (108) with the inlet port (114) of the second coolant block (110),
**characterized in that** the connecting structure comprises a distribution plate (138) configured to be mounted onto the first and second coolant blocks (108, 110),
wherein the distribution plate (138) includes a block interconnecting channel (144) configured to connect the outlet port (116) of the first coolant block (108) with the inlet port (114) of the second coolant block (110) for allowing the coolant to flow from said outlet port (116) to said inlet port (114).

2. The cooling device (100) according to claim 1, wherein the distribution plate (138) further includes an inlet opening (156) configured to be connected with an inlet tube (192) for introducing the coolant into the cooling device (100), wherein the inlet opening (156) of the distribution plate (138) is configured to communicate with the inlet port (112) of the first coolant block (108).

3. The cooling device (100) according to claim 1 or 2, wherein the distribution plate (138) further includes a coolant output channel (146) configured to connect the outlet port (118) of the second coolant block (110) with an outlet opening (190) of the distribution plate (138),
wherein the outlet opening (190) of the distribution plate (138) is configured to be connected with an outlet tube (194) for outputting the coolant from cooling device (100).

4. The cooling device (100) according to one of the preceding claims, comprising a fixation plate (158) configured to be mounted onto the first and second coolant blocks (108, 110),
wherein distribution plate (138) is configured to be mounted onto the fixation plate (158).

5. The cooling device (100) according to claim 4, wherein each of the inlet and outlet ports (112, 114, 116, 118) of the first and second coolant blocks (108, 110) is provided with a fitting (130-136) which is configured to be connected with the distribution plate (138),
wherein the fixation plate (158) comprises a plurality of through holes (160-166), each of which being assigned to one the fittings (130-136), and
wherein each fitting (130-136) is configured to pass through the corresponding through hole (160-166) of the fixation plate (158) for connecting the fitting (130-136) with the distribution plate (138).

6. The cooling device (100) according to claim 5, wherein the fitting (130) provided to the inlet port (112) of the first coolant block (108) is configured to be connected with the inlet opening (156) of the distribution plate (138),
wherein the fitting (134) provided to the outlet port (116) of the first coolant block (108) is configured to be connected with an inlet end (148) of the block interconnecting channel (144) of the distribution plate (138),
wherein the fitting (132) provided to the inlet port (114) of the second coolant block (110) is configured to be connected with an outlet end (150) of the block interconnecting channel (144) of the distribution plate (138), and
wherein the fitting (136) provided to the outlet port (118) of the second coolant block (110) is configured to be connected with an inlet end (152) of the coolant output channel (146) of the distribution plate (138).

7. The cooling device (100) according to claim 5 or 6, wherein the fixation plate (158) is movable from an unlocked position, in which each fitting (130-136) is unlocked within the corresponding through hole (160-166) of the fixation plate (158), into a locked position, in which each fitting (130-136) is locked within the corresponding through hole (160-166) of the fixation plate (158).

8. The cooling device (100) according to claim 7, further comprising a fastening structure including at least one pair of first and second fastening elements and at least one through hole, said first fastening element (168, 170, 172) being formed on the fixation plate (158) and said through hole (174, 176, 178) being formed in the distribution plate (138), wherein the first fastening element (168, 170, 172) is aligned with the through hole (174, 176, 178) and the second fastening element (180, 182, 184) is insertable into the through hole (174, 176, 178) to be connected with the first fastening element (168, 170, 172) for mounting the distribution plate (138) onto the fixation plate (158) when the fixation plate (158) is in the locked position.

9. The cooling device (100) according to claim 7 or 8, wherein each fitting (130-136) comprises a shaft (136a) and a circumferential flange (136b) radially protruding therefrom,
wherein each through hole (160-166) of the fixation plate (158) comprises an insertion hole portion (166a) and a locking hole portion (166b), said insertion hole portion (166a) having a cross section being larger than a cross section of the flange (136b) and said locking hole portion (166b) having a cross section being smaller than the cross section of the flange (136b),
wherein the flange (136b) is positioned in an unlocked manner within the insertion hole portion (166a) when the fixation plate (158) is in the unlocked position, and
wherein the flange (136b) is positioned in a locked manner within the locking hole portion (166b) when the fixation plate (158) is in the locked position.

10. The cooling device (100) according to one of the claims 3 to 9, wherein the distribution plate (138) is formed by two plates (140, 142) attached to each other, and
wherein each of the block interconnecting channel (144) and the coolant output channel (146) is defined by a groove, said groove being formed in one of the plates and being covered by the other plate.

11. A computer module (102), comprising a first computer component (106), at least a second computer component and a cooling device (100) according to one of the preceding claims for cooling the first and second computer components.

12. The computer module (102) according to claim 11, wherein the first and second coolant blocks (108, 110) are mounted on a circuit board (104) carrying the computer components.

13. A method for installing a cooling device (100) according to one the claims 1 to 10 in a computer module (102) including a first computer component (106) and at least a second computer component, comprising following steps:
mounting the first coolant block (108) onto the first computer component (106),
mounting the second coolant block (110) onto the second computer component, and
mounting the distribution plate (138) onto the first and second coolant blocks (108, 110) thereby connecting the outlet port (116) of the first coolant block (108) with the inlet port (114) of the second coolant block (110) by means of the interconnecting channel (144) of the distribution plate (138) for allowing the coolant to flow from said outlet port (116) to said inlet port (114).

14. The method according to claim 13, wherein the outlet port (118) of the second coolant block (110) is connected with the outlet opening (190) of the distribution plate (116) by means of the coolant output channel (146) of the distribution plate (138) by mounting the distribution plate (138) onto the first and second coolant blocks (108, 110).

15. The method according to claim 14, wherein the inlet opening (156) of the distribution plate (138) is connected with an inlet tube (192) for introducing the coolant into the cooling device (100) and the outlet opening (190) of the distribution plate (138) is connected with an outlet tube (194) for outputting the coolant from the cooling device (100).

## Patentansprüche

1. Kühlvorrichtung (100) für ein Computermodul (102), umfassend:
einen ersten Kühlmittelblock (108), der ausgebildet ist, auf einer ersten Computerkomponente (106) angebracht zu werden, und mindestens einen zweiten Kühlmittelblock (110), der ausgebildet ist, dass auf einer zweiten Computerkomponente angebracht zu werden, wobei sowohl der erste als auch der zweite Kühlmittelblock (108, 110) eine Einlassöffnung (112, 114) umfasst, die ausgebildet ist, ein Kühlmittel in den Kühlmittelblock (108, 110) fließen zu lassen, sowie eine Auslassöffnung (116, 118), die ausgebildet ist, das Kühlmittel aus dem Kühlmittelblock (108, 110) fließen zu lassen, und
eine Verbindungsstruktur, die ausgebildet ist, die Auslassöffnung (116) des ersten Kühlmittelblocks (108) mit der Einlassöffnung (114) des zweiten Kühlmittelblocks (110) zu verbinden,
**dadurch gekennzeichnet, dass** die Verbindungsstruktur eine Verteilerplatte (138) umfasst, die ausgebildet ist, auf den ersten und zweiten Kühlmittelblock (108, 110) montiert zu werden,
wobei die Verteilerplatte (138) einen Blockverbindungskanal (144) enthält, der ausgebildet ist, die Auslassöffnung (116) des ersten Kühlmittelblocks (108) mit der Einlassöffnung (114) des zweiten Kühlmittelblocks (110) zu verbinden, damit das Kühlmittel von der Auslassöffnung (116) zur Einlassöffnung (114) fließen kann.

2. Kühlvorrichtung (100) nach Anspruch 1, wobei die Verteilerplatte (138) ferner eine Einlassöffnung (156) aufweist, die ausgebildet ist, mit einem Einlassrohr (192) zum Einleiten des Kühlmittels in die Kühlvorrichtung (100) verbunden zu werden,
wobei die Einlassöffnung (156) der Verteilerplatte (138) ausgebildet ist, mit der Einlassöffnung (112) des ersten Kühlmittelblocks (108) in Verbindung zu stehen.

3. Kühlvorrichtung (100) nach Anspruch 1 oder 2, wobei die Verteilerplatte (138) ferner einen Kühlmittelauslasskanal (146) aufweist, der ausgebildet ist, die Auslassöffnung (118) des zweiten Kühlmittelblocks (110) mit einer Auslassöffnung (190) der Verteilerplatte (138) zu verbinden,
wobei die Auslassöffnung (190) der Verteilerplatte (138) ausgebildet ist, mit einem Auslassrohr (194) zum Auslassen des Kühlmittels aus der Kühlvorrichtung (100) verbunden zu werden.

4. Kühlvorrichtung (100) nach einem der vorhergehenden Ansprüche, umfassend eine Befestigungsplatte (158), die ausgebildet ist, auf den ersten und zweiten Kühlmittelblock (108, 110) montiert zu werden,
wobei die Verteilerplatte (138) ausgebildet ist, an der Befestigungsplatte (158) angebracht zu werden.

5. Kühlvorrichtung (100) nach Anspruch 4, wobei jede der Einlass- und Auslassöffnungen (112, 114, 116, 118) des ersten und zweiten Kühlmittelblocks (108, 110) mit einem Anschlussstück (130-136) versehen ist, das ausgebildet ist, mit der Verteilerplatte (138) verbunden zu werden,
wobei die Befestigungsplatte (158) eine Vielzahl von Durchgangslöchern (160-166) aufweist, von denen jedes einem der Anschlussstücke (130-136) zugeordnet ist, und
wobei jedes Anschlussstück (130-136) ausgebildet ist, durch das entsprechende Durchgangsloch (160-166) der Befestigungsplatte (158) hindurchzugehen, um das Anschlussstück (130-136) mit der Verteilerplatte (138) zu verbinden.

6. Kühlvorrichtung (100) nach Anspruch 5, wobei das an der Einlassöffnung (112) des ersten Kühlmittelblocks (108) vorgesehene Anschlussstück (130) ausgebildet ist, mit der Einlassöffnung (156) der Verteilerplatte (138) verbunden zu werden,
wobei das Anschlussstück (134), das an der Auslassöffnung (116) des ersten Kühlmittelblocks (108) vorgesehen ist, ausgebildet ist, mit einem Einlassende (148) des Blockverbindungskanals (144) der Verteilerplatte (138) verbunden zu werden,
wobei das Anschlussstück (132), das an der Einlassöffnung (114) des zweiten Kühlmittelblocks (110) vorgesehen ist, ausgebildet ist, mit einem Auslassende (150) des Blockverbindungskanals (144) der Verteilerplatte (138) verbunden zu werden, und
wobei das an der Auslassöffnung (118) des zweiten Kühlmittelblocks (110) vorgesehene Anschlussstück (136) ausgebildet ist, mit einem Einlassende (152) des Kühlmittelauslasskanals (146) der Verteilerplatte (138) verbunden zu werden.

7. Kühlvorrichtung (100) nach Anspruch 5 oder 6, wobei die Befestigungsplatte (158) aus einer entriegelten Position, in der jedes Anschlussstück (130-136) innerhalb des entsprechenden Durchgangslochs (160-166) der Befestigungsplatte (158) entriegelt ist, in eine verriegelte Position bewegbar ist, in der jedes Anschlussstück (130-136) innerhalb des entsprechenden Durchgangslochs (160-166) der Befestigungsplatte (158) verriegelt ist.

8. Kühlvorrichtung (100) nach Anspruch 7, die ferner eine Befestigungsstruktur mit mindestens einem Paar erster und zweiter Befestigungselemente und mindestens einem Durchgangsloch umfasst, wobei das erste Befestigungselement (168, 170, 172) an der Befestigungsplatte (158) ausgebildet ist und das Durchgangsloch (174, 176, 178) in der Verteilerplatte (138) ausgebildet ist, wobei das erste Befestigungselement (168, 170, 172) mit dem Durchgangsloch (174, 176, 178) ausgerichtet ist und das zweite Befestigungselement (180, 182, 184) in das Durchgangsloch (174, 176, 178) einführbar ist, um mit dem ersten Befestigungselement (168, 170, 172) verbunden zu werden, um die Verteilerplatte (138) auf der Befestigungsplatte (158) zu montieren, wenn die Befestigungsplatte (158) in der verriegelten Position ist.

9. Kühlvorrichtung (100) nach Anspruch 7 oder 8, wobei jedes Anschlussstück (130-136) einen Schaft (136a) und einen davon radial abstehenden Umfangsflansch (136b) aufweist,
wobei jedes Durchgangsloch (160-166) der Befestigungsplatte (158) einen Einführungslochabschnitt (166a) und einen Verriegelungslochabschnitt (166b) umfasst, wobei der Einführungslochabschnitt (166a) einen Querschnitt aufweist, der größer als ein Querschnitt des Flansches (136b) ist, und der Verriegelungslochabschnitt (166b) einen Querschnitt aufweist, der kleiner als der Querschnitt des Flansches (136b) ist,
wobei der Flansch (136b) in unverriegelter Weise innerhalb des Einführungslochabschnitts (166a) positioniert ist, wenn sich die Befestigungsplatte (158) in der unverriegelten Position befindet, und
wobei der Flansch (136b) in einer verriegelten Weise innerhalb des Verriegelungslochabschnitts (166b) positioniert ist, wenn sich die Befestigungsplatte (158) in der verriegelten Position befindet.

10. Kühlvorrichtung (100) nach einem der Ansprüche 3 bis 9, wobei die Verteilerplatte (138) durch zwei aneinander befestigte Platten (140, 142) gebildet ist, und wobei der Blockverbindungskanal (144) und der Kühlmittelauslasskanal (146) jeweils durch eine Nut definiert sind, wobei die Nut in einer der Platten ausgebildet ist und von der anderen Platte abgedeckt wird.

11. Computermodul (102), umfassend eine erste Computerkomponente (106), mindestens eine zweite Computerkomponente und eine Kühleinrichtung (100) nach einem dervorhergehenden Ansprüche zur Kühlung der ersten und zweiten Computerkomponente.

12. Computermodul (102) nach Anspruch 11, wobei der erste und der zweite Kühlmittelblock (108, 110) auf einer Leiterplatte (104) montiert sind, die die Computerkomponenten trägt.

13. Verfahren zum Einbau einer Kühlvorrichtung (100) nach einem der Ansprüche 1 bis 11 in ein Computermodul (102) mit einer ersten Computerkomponente (106) und mindestens einer zweiten Computerkomponente, umfassend die folgenden Schritte:
Anbringen des ersten Kühlmittelblocks (108) auf der ersten Computerkomponente (106),
Anbringen des zweiten Kühlmittelblocks (110) auf der zweiten Computerkomponente, und
Anbringen der Verteilerplatte (138) auf dem ersten und zweiten Kühlmittelblock (108, 110), wodurch die Auslassöffnung (116) des ersten Kühlmittelblocks (108) mit der Einlassöffnung (114) des zweiten Kühlmittelblocks (110) mittels des Verbindungskanals (144) der Verteilerplatte (138) verbunden wird, damit das Kühlmittel von der Auslassöffnung (116) zu der Einlassöffnung (114) fließen kann.

14. Verfahren nach Anspruch 13, bei dem die Auslassöffnung (118) des zweiten Kühlmittelblocks (110) mit der Auslassöffnung (190) der Verteilerplatte (116) über den Kühlmittelauslasskanal (146) der Verteilerplatte (138) verbunden wird, indem die Verteilerplatte (138) auf den ersten und zweiten Kühlmittelblock (108, 110) montiert wird.

15. Verfahren nach Anspruch 14, wobei die Einlassöffnung (156) der Verteilerplatte (138) mit einem Einlassrohr (192) zum Einleiten des Kühlmittels in die Kühlvorrichtung (100) und die Auslassöffnung (190) der Verteilerplatte (138) mit einem Auslassrohr (194) zur Ausgabe des Kühlmittels aus der Kühlvorrichtung (100) verbunden ist.

## Revendications

1. Dispositif de refroidissement (100) pour un module informatique (102), comprenant :
un premier bloc de liquide de refroidissement (108) configuré pour être monté sur un premier composant informatique (106) et au moins un second bloc de liquide de refroidissement (110) configuré pour être monté sur un second composant informatique, dans lequel chacun des premier et second blocs de liquide de refroidissement (108, 110) comprend un port d'entrée (112, 114) configuré pour permettre à un liquide de refroidissement de s'écouler dans le bloc de liquide de refroidissement (108, 110) et un port de sortie (116, 118) configuré pour permettre au liquide de refroidissement de s'écouler hors du bloc de liquide de refroidissement (108, 110), et
une structure de connexion configurée pour connecter le port de sortie (116) du premier bloc de liquide de refroidissement (108) au port d'entrée (114) du second bloc de liquide de refroidissement (110),
**caractérisé en ce que** la structure de connexion comprend une plaque de distribution (138) configurée pour être montée sur les premier et second blocs de liquide de refroidissement (108, 110),
dans lequel la plaque de distribution (138) comprend un canal d'interconnexion de blocs (144) configuré pour connecter le port de sortie (116) du premier bloc de liquide de refroidissement (108) au port d'entrée (114) du second bloc de liquide de refroidissement (110) pour permettre au liquide de refroidissement de s'écouler dudit port de sortie (116) vers ledit port d'entrée (114).

2. Dispositif de refroidissement (100) selon la revendication 1, dans lequel la plaque de distribution (138) comprend en outre une ouverture d'entrée (156) configurée pour être connectée à un tube d'entrée (192) pour introduire le liquide de refroidissement dans le dispositif de refroidissement (100),
dans lequel l'ouverture d'entrée (156) de la plaque de distribution (138) est configurée pour communiquer avec le port d'entrée (112) du premier bloc de liquide de refroidissement (108).

3. Dispositif de refroidissement (100) selon la revendication 1 ou 2, dans lequel la plaque de distribution (138) comprend en outre un canal de sortie de liquide de refroidissement (146) configuré pour connecter le port de sortie (118) du second bloc de liquide de refroidissement (110) avec une ouverture de sortie (190) de la plaque de distribution (138),
dans lequel l'ouverture de sortie (190) de la plaque de distribution (138) est configurée pour être connectée à un tube de sortie (194) pour la sortie du liquide de refroidissement depuis le dispositif de refroidissement (100).

4. Dispositif de refroidissement (100) selon l'une des revendications précédentes, comprenant une plaque de fixation (158) configurée pour être montée sur les premier et second blocs de liquide de refroidissement (108, 110),
dans lequel la plaque de distribution (138) est configurée pour être montée sur la plaque de fixation (158).

5. Dispositif de refroidissement (100) selon la revendication 4, dans lequel chacun des ports d'entrée et de sortie (112, 114, 116, 118) des premier et second blocs de de liquide de refroidissement (108, 110) est muni d'un raccord (130-136) qui est configuré pour être connecté à la plaque de distribution (138),
dans lequel la plaque de fixation (158) comprend une pluralité de trous traversants (160-166), chacun étant affecté à l'un des raccords (130-136), et
dans lequel chaque raccord (130-136) est configuré pour passer à travers le trou traversant correspondant (160-166) de la plaque de fixation (158) pour connecter le raccord (130-136) à la plaque de distribution (138).

6. Dispositif de refroidissement (100) selon la revendication 5, dans lequel le raccord (130) fourni au port d'entrée (112) du premier bloc de liquide de refroidissement (108) est configuré pour être connecté à l'ouverture d'entrée (156) de la plaque de distribution (138),
dans lequel le raccord (134) fourni au port de sortie (116) du premier bloc de liquide de refroidissement (108) est configuré pour être connecté à une extrémité d'entrée (148) du canal d'interconnexion de blocs (144) de la plaque de distribution (138),
dans lequel le raccord (132) fourni au port d'entrée (114) du second bloc de liquide de refroidissement (110) est configuré pour être connecté à une extrémité de sortie (150) du canal d'interconnexion de blocs (144) de la plaque de distribution (138), et
dans lequel le raccord (136) fourni au port de sortie (118) du second bloc de liquide de refroidissement (110) est configuré pour être connecté à une extrémité d'entrée (152) du canal de sortie de liquide de refroidissement (146) de la plaque de distribution (138).

7. Dispositif de refroidissement (100) selon la revendication 5 ou 6, dans lequel la plaque de fixation (158) peut passer d'une position déverrouillée, dans laquelle chaque raccord (130-136) est déverrouillé dans le trou traversant correspondant (160-166) de la plaque de fixation (158), à une position verrouillée, dans laquelle chaque raccord (130-136) est verrouillé dans le trou traversant correspondant (160-166) de la plaque de fixation (158).

8. Dispositif de refroidissement (100) selon la revendication 7, comprenant en outre une structure d'arrimage comprenant au moins une paire de premier et second éléments d'arrimage et au moins un trou traversant, ledit premier élément d'arrimage (168, 170, 172) étant formé sur la plaque de fixation (158) et ledit trou traversant (174, 176, 178) étant formé dans la plaque de distribution (138), dans lequel le premier élément d'arrimage (168, 170, 172) est aligné avec le trou traversant (174, 176, 178) et le second élément d'arrimage (180, 182, 184) peut être inséré dans le trou traversant (174, 176, 178) pour être connecté au premier élément d'arrimage (168, 170, 172) pour le montage de la plaque de distribution (138) sur la plaque de fixation (158) lorsque la plaque de fixation (158) est en position verrouillée.

9. Dispositif de refroidissement (100) selon la revendication 7 ou 8, dans lequel chaque raccord (130-136) comprend un arbre (136a) et une bride circonférentielle (136b) faisant radialement saillie depuis celui-ci,
dans lequel chaque trou traversant (160-166) de la plaque de fixation (158) comprend une partie de trou d'insertion (166a) et une partie de trou de verrouillage (166b), ladite partie de trou d'insertion (166a) ayant une section transversale qui est supérieure à une section transversale de la bride (136b) et ladite partie de trou de verrouillage (166b) ayant une section transversale qui est inférieure à la section transversale de la bride (136b),
dans lequel la bride (136b) est positionnée d'une manière déverrouillée dans la partie de trou d'insertion (166a) lorsque la plaque de fixation (158) est en position déverrouillée, et
dans lequel la bride (136b) est positionnée d'une manière verrouillée dans la partie de trou de verrouillage (166b) lorsque la plaque de fixation (158) est en position verrouillée.

10. Dispositif de refroidissement (100) selon l'une des revendications 3 à 9, dans lequel la plaque de distribution (138) est formée de deux plaques (140, 142) fixées l'une à l'autre, et
dans lequel chacun du canal d'interconnexion de blocs (144) et du canal de sortie de liquide de refroidissement (146) est défini par une rainure, ladite rainure étant formée dans l'une des plaques et étant recouverte par l'autre plaque.

11. Module informatique (102), comprenant un premier composant informatique (106), au moins un second composant informatique et un dispositif de refroidissement (100) selon l'une des revendications précédentes pour refroidir les premier et second composants informatiques.

12. Module informatique (102) selon la revendication 11, dans lequel les premier et second blocs de liquide de refroidissement (108, 110) sont montés sur une carte de circuit imprimé (104) supportant les composants informatiques.

13. Procédé d'installation d'un dispositif de refroidissement (100) selon l'une des revendications 1 à 10 dans un module informatique (102) comprenant un premier composant informatique (106) et au moins un second composant informatique, comprenant les étapes suivantes :
le montage du premier bloc de liquide de refroidissement (108) sur le premier composant informatique (106),
le montage du second bloc de liquide de refroidissement (110) sur le second composant informatique, et
le montage de la plaque de distribution (138) sur les premier et second blocs de liquide de refroidissement (108, 110), connectant ainsi le port de sortie (116) du premier bloc de liquide de refroidissement (108) au port d'entrée (114) du second bloc de liquide de refroidissement (110) au moyen du canal d'interconnexion (144) de la plaque de distribution (138) pour permettre au liquide de refroidissement de s'écouler dudit port de sortie (116) vers ledit port d'entrée (114).

14. Procédé selon la revendication 13, dans lequel le port de sortie (118) du second bloc de liquide de refroidissement (110) est connecté à l'ouverture de sortie (190) de la plaque de distribution (116) au moyen du canal de sortie de liquide de refroidissement (146) de la plaque de distribution (138) en montant la plaque de distribution (138) sur les premier et second blocs de liquide de refroidissement (108, 110).

15. Procédé selon la revendication 14, dans lequel l'ouverture d'entrée (156) de la plaque de distribution (138) est connectée à un tube d'entrée (192) pour introduire le liquide de refroidissement dans le dispositif de refroidissement (100) et l'ouverture de sortie (190) de la plaque de distribution (138) est connectée à un tube de sortie (194) pour la sortie du liquide de refroidissement depuis le dispositif de refroidissement (100).
